# EUROPÄISCHE PATENTANMELDUNG

(11) **EP 3 955 282 A1**
(43) Veröffentlichungstag der Anmeldung: **16.02.2022**
(21) Anmeldenummer: 20190396.0
(22) Anmeldetag: 11.08.2020
(51) Int. Cl.: H01L 23/049, H01L 23/367, H01L 23/373

(54) **LEISTUNGSMODUL MIT MINDESTENS EINER LEISTUNGSEINHEIT**

(71) Anmelder: Siemens Aktiengesellschaft, 80333 München (DE)
(72) Erfinder: Kögler, Roman, 90403 Nürnberg (DE); Luft, Alexander, 90766 Fürth (DE); Roppelt, Bernd, 96191 Viereth-Trunstadt (DE); Schmenger, Jens, 91301 Forchheim (DE); Schwinn, Thomas, 91074 Herzogenaurach (DE)

(57) **Zusammenfassung**

Die Erfindung betrifft ein Leistungsmodul (2) mit mindestens einer Leistungseinheit (4), welche mindestens einen Leistungshalbleiter (6) und ein Substrat (8) umfasst. Um die Zuverlässigkeit des Leistungsmoduls (2) zu verbessern wird vorgeschlagen, dass das Substrat (8) der Leistungseinheit (4) unmittelbar stoffschlüssig mit einer Oberfläche (10) eines Kühlkörpers (12) verbunden ist, wobei die mindestens eine Leistungseinheit (4) zumindest teilweise von einem Gehäuse (14) umgeben ist, wobei das Gehäuse (14) einen Gehäuserahmen (16) aus einem ersten dielektrischen Werkstoff und einen Gehäusedeckel (18) aus einem zweiten dielektrischen Werkstoff umfasst, wobei sich der erste dielektrische Werkstoff vom zweiten dielektrischen Werkstoff unterscheidet und wobei der Gehäuserahmen (16) flüssigkeitsdicht mit der Oberfläche (10) des Kühlkörpers (12) verbunden ist und wobei das Gehäuse (14) durch Verbinden des Gehäusedeckels (18) mit dem Gehäuserahmen (16) verschlossen ist.

## Beschreibung

Die Erfindung betrifft ein Leistungsmodul mit mindestens einer Leistungseinheit.

Ferner betrifft die Erfindung einen Stromrichter mit mindestens einem derartigen Leistungsmodul.

Darüber hinaus betrifft die Erfindung ein Verfahren zur Herstellung eines Leistungsmoduls mit mindestens einer Leistungseinheit.

In derartigen Stromrichtern werden in der Regel abgeschlossene Schalter-Module, die derzeit in diskreten Bauformen gefertigt werden, beispielweise über eine massive metallische Bodenplatte, auf einen Kühlkörper aufgeschraubt. Unter einem Stromrichter ist beispielsweise ein Gleichrichter, ein Wechselrichter, ein Umrichter oder ein Gleichspannungswandler zu verstehen.

In derartigen Schalter-Modulen wird auf Grund ansteigender maximal zulässiger Chiptemperaturen der Leistungshalbleiter, welche beispielsweise im Bereich von 175°C liegen, auch die die Leistungshalbleiter umgebende Peripherie stetig wärmer. Dies betrifft insbesondere Gehäuse, welche die Leistungshalbleiter umgeben und üblicherweise aus einem Kunststoff hergestellt sind. Die steigenden Temperaturen im Innenraum von Schalter-Modulen stellen somit auch eine Herausforderung für die die Leistungshalbleiter umgebenden Gehäuse dar. Der Einsatz von höheren temperaturbeständigen Kunststoffen, beispielsweise PPS-Material, bringt andere Nachteile mit sich. Derartige höhere temperaturbeständige Kunststoffe weisen beispielsweise einen hohen Glasfaseranteil auf, der den Werkstoff spröde macht, was, insbesondere bei mechanischer Belastung, zu einer Rissbildung und schließlich zum Bruch führt.

Vor diesem Hintergrund ist es eine Aufgabe der vorliegenden Erfindung, die Zuverlässigkeit eines Leistungsmoduls zu verbessern.

Die Aufgabe wird erfindungsgemäß gelöst durch ein Leistungsmodul mit mindestens einer Leistungseinheit, welche mindestens einen Leistungshalbleiter und ein Substrat umfasst, wobei das Substrat der Leistungseinheit unmittelbar stoffschlüssig mit einer Oberfläche eines Kühlkörpers verbunden ist, wobei die mindestens eine Leistungseinheit zumindest teilweise von einem Gehäuse umgeben ist, wobei das Gehäuse einen Gehäuserahmen aus einem ersten dielektrischen Werkstoff und einen Gehäusedeckel aus einem zweiten dielektrischen Werkstoff umfasst, wobei sich der erste dielektrische Werkstoff vom zweiten dielektrischen Werkstoff unterscheidet und wobei der Gehäuserahmen flüssigkeitsdicht mit der Oberfläche des Kühlkörpers verbunden ist und wobei das Gehäuse durch Verbinden des Gehäusedeckels mit dem Gehäuserahmen verschlossen ist.

Ferner wird die Aufgabe erfindungsgemäß durch einen Stromrichter mit mindestens einem derartigen Leistungsmodul gelöst.

Darüber hinaus wird die Aufgabe erfindungsgemäß gelöst durch ein Verfahren zur Herstellung eines Leistungsmoduls mit mindestens einer Leistungseinheit, welche mindestens einen Leistungshalbleiter und ein Substrat umfasst, wobei das Substrat der Leistungseinheit unmittelbar stoffschlüssig mit einer Oberfläche eines Kühlkörpers verbunden ist, wobei ein Gehäuse um die mindestens eine Leistungseinheit angeordnet wird, wobei das Gehäuse einen Gehäuserahmen aus einem ersten dielektrischen Werkstoff und einen Gehäusedeckel aus einem zweiten dielektrischen Werkstoff umfasst, wobei sich der erste dielektrische Werkstoff vom zweiten dielektrischen Werkstoff unterscheidet, wobei der Gehäuserahmen flüssigkeitsdicht mit der Oberfläche des Kühlkörpers verbunden wird und wobei das Gehäuse durch Verbinden des Gehäusedeckels mit dem Gehäuserahmen verschlossen wird.

Die in Bezug auf das Leistungsmodul nachstehend angeführten Vorteile und bevorzugten Ausgestaltungen lassen sich sinngemäß auf den Stromrichter und das Verfahren übertragen.

Der Erfindung liegt die Überlegung zugrunde, die Zuverlässigkeit eines Leistungsmoduls durch ein Gehäuse zu verbessern, das eine Leistungseinheit des Leistungsmoduls zumindest teilweise umgibt. Die Leistungseinheit weist mindestens einen Leistungshalbleiter und ein Substrat auf. Das Substrat weist eine dielektrische Materiallage mit einer, insbesondere beidseitigen, Metallisierung auf. Beispielsweise ist die dielektrische Materiallage 25 µm bis 400 µm, insbesondere 50 µm bis 250 µm, dick und enthält einen keramischen Werkstoff, beispielsweise Aluminiumnitrid oder Aluminiumoxid, oder einen organischen Werkstoff, beispielsweise einem Polyamid. Die Metallisierung ist beispielsweise strukturiert ausgeführt und aus Kupfer hergestellt.

Das Substrat ist unmittelbar stoffschlüssig mit einer Oberfläche eines Kühlkörpers verbunden. Unter einem Kühlkörper ist eine metallische Bodenplatte zu verstehen, die Kühlrippen oder andere Mittel zur Vergrößerung der Oberfläche aufweisen kann. Der Kühlkörper ist beispielsweise aus Aluminium oder einer Aluminiumlegierung durch Strangpressen hergestellt. Unter einer unmittelbar stoffschlüssigen Verbindung ist eine direkte Verbindung zu verstehen, die Verbindungsmittel zur Herstellung der stoffschlüssigen Verbindung wie Kleber, Lötzinn, Sinterpaste, ... einschließt, ein zusätzliches Verbindungselement wie einen zusätzlichen Leiter, einen Bonddraht, einen Abstandshalter, eine Bodenplatte, Wärmeleitpaste, ... jedoch ausschließt.

Das Gehäuse umfasst einen Gehäuserahmen und einen Gehäusedeckel, wobei das Gehäuse durch Verbinden des Gehäusedeckels mit dem Gehäuserahmen verschlossen ist. Der Gehäuserahmen ist flüssigkeitsdicht mit der Oberfläche des Kühlkörpers verbunden, sodass beispielsweise ein Weichverguss, insbesondere ein Silikonverguss, innerhalb des Gehäuserahmens zum Schutz der Leistungshalbleiter vorsehbar ist. Die flüssigkeitsdichte Verbindung ist beispielsweise adhäsiv, durch Kraftschluss oder durch Formschluss herstellbar. Durch die Verbindung des Gehäuserahmens mit dem Kühlkörper wird eine Temperaturbelastung des Gehäuses auch bei hohen Temperaturen der Leistungshalbleiter, beispielsweise im Bereich von 175°C, reduziert.

Der Gehäuserahmen ist aus einem ersten dielektrischen Werkstoff und der Gehäusedeckel aus einem zweiten dielektrischen Werkstoff hergestellt, wobei sich der erste dielektrische Werkstoff vom zweiten dielektrischen Werkstoff unterscheidet. Insbesondere unterscheidet sich der erste dielektrische Werkstoff vom zweiten dielektrischen Werkstoff durch seine mechanischen, elektrischen und thermischen Eigenschaften. Durch die Verwendung unterschiedlicher dielektrischer Werkstoffe für den Gehäuserahmen und den Gehäusedeckel ergibt sich eine Vielzahl von Freiheitsgraden zur Optimierung der mechanischen, elektrischen und thermischen Eigenschaften des Gehäuses, um eine verbesserte Zuverlässigkeit des Leistungsmoduls zu erreichen. Insbesondere ermöglicht die Verwendung unterschiedlicher dielektrischer Werkstoffe ein Gehäuse, welches auch bei hohen Temperaturen der Leistungshalbleiter die Lebensdauer des Leistungsmoduls nicht merklich beeinträchtigt.

Eine weitere Ausführungsform sieht vor, dass der Gehäusedeckel lösbar mit dem Gehäuserahmen verbunden ist. Eine reversible Verbindung ist beispielsweise über eine kraftschlüssige Verbindung zwischen Gehäusedeckel und Gehäuserahmen herstellbar. Durch einen vom Gehäuserahmen lösbaren Gehäusedeckel ist die Leistungseinheit, beispielsweise bei in der Produktion oder im Betrieb auftretenden Fehlern, zerstörungsfrei analysierbar.

Eine weitere Ausführungsform sieht vor, dass der Gehäusedeckel formschlüssig mit dem Gehäuserahmen verbunden ist. Eine formschlüssige Verbindung ist beispielsweise eine Schnappverbindung des Gehäusedeckels. Die Schnappverbindung ist beispielsweise über einen, zumindest im Bereich der Schnappverbindung, elastisch verformbaren Gehäusedeckel, herstellbar, welcher zur Herstellung der Schnappverbindung im Gehäuserahmen verhakt wird. Durch einen formschlüssig verbundenen Deckel ist die Leistungseinheit, beispielsweise bei in der Produktion oder im Betrieb auftretenden Fehlern, besonders einfach zerstörungsfrei analysierbar.

Eine weitere Ausführungsform sieht vor, dass der erste dielektrische Werkstoff eine höhere Durchschlagfestigkeit und/oder eine höhere Temperaturstabilität aufweist als der zweite dielektrische Werkstoff. Da der Gehäusedeckel keinen direkten Kontakt zum durch die Leistungshalbleiter erwärmten Kühlkörper hat und somit eine geringere Temperatur als der Gehäuserahmen aufweist, ist eine geringere Temperaturstabilität ausreichend. Insbesondere bei der Verwendung eines Weichvergusses innerhalb des Gehäuserahmens, kann der Gehäusedeckel eine geringere Durchschlagfestigkeit als der Gehäuserahmen aufweisen. Daher ist für den Gehäusedeckel ein kostengünstigerer Werkstoff verwendbar.

Eine weitere Ausführungsform sieht vor, dass der erste dielektrische Werkstoff eine höhere mechanische Steifigkeit aufweist als der zweite dielektrische Werkstoff. Beispielsweise ist der Gehäusedeckel, welcher den zweiten dielektrischen Werkstoff umfasst, durch eine geringere mechanische Steifigkeit zur Herstellung einer Schnappverbindung zum Gehäuserahmen elastisch verformbar.

Eine weitere Ausführungsform sieht vor, dass der erste dielektrische Werkstoff ein Reaktionsharz enthält und/oder einen Faseranteil von 50 % bis 75 %, insbesondere 60 % bis 65 %, aufweist. Ein Reaktionsharz ist beispielsweise ein Epoxidharz. Für die Füllung werden beispielsweise Glas- und/oder Kohlefasern verwendet, wodurch eine hohe Festigkeit und/oder Steifigkeit erzielbar ist. Ferner wird für den ersten dielektrischen Werkstoff eine hohe Durchschlagfestigkeit erzielt.

Eine weitere Ausführungsform sieht vor, dass der zweite dielektrische Werkstoff einen thermoplastischen Kunststoff enthält und/oder einen Faseranteil von 5 % bis 15 % aufweist. Ein derartiger thermoplastischer Kunststoff ist beispielsweise Polycarbonat. Für die Füllung werden beispielsweise Glas- und/oder Kohlefasern verwendet. Durch einen derartigen Faseranteil wird für den zweiten dielektrischen Werkstoff eine hohe Elastizität, beispielsweise zur Herstellung einer Schnappverbindung, erreicht.

Eine weitere Ausführungsform sieht vor, dass ein im Wesentlichen parallel zur Oberfläche des Kühlkörpers verlaufend angeordnetes Power-Board über orthogonale Kontakte mit der Leistungseinheit verbunden ist, wobei der Gehäusedeckel Aussparungen zur Durchführung der orthogonalen Kontakte aufweist. Unter einem orthogonalen Kontakt ist beispielsweise ein Pin zu verstehen, der durch seine strukturellen Eigenschaften senkrecht auf einem Substrat angeordnet werden kann. Derartige strukturelle Eigenschaften sind beispielsweise ein Fuß, der es dem Pin, beispielsweise durch eine stoffschlüssige Verbindung mit dem Substrat, erlaubt auf dem Substrat angeordnet zu werden und/oder ein Taumelkreis, der eine Findung einer Bohrung im Power-Board erleichtert und für mehr Stabilität und Robustheit, z.B. bei einer thermischen Ausdehnung während des Betriebes, sorgt. Beispielsweise sind die orthogonalen Kontakte auf dem Substrat aufgelötet und mittels einer Presspass-Verbindung mit dem Power-Board verbunden. Ein derartiger Kontakt ist beispielsweise aus Kupfer oder einer Kupferlegierung hergestellt, um einen geringen Widerstand und eine hohe Stromtragfähigkeit zu erreichen. Durch die senkrechte Anordnung der Kontakte werden kurze Leitungswege und damit verbundene niedrige Induktivitäten erreicht, was Leistungseinheiten mit niedrigen Impedanzen und geringen Verlusten ermöglicht.

Eine weitere Ausführungsform sieht vor, dass das Power-Board eine Metallisierung aufweist, wobei die Metallisierung zumindest teilweise ausgespart ist. Insbesondere ist die Metallisierung zwischen Potentialen unterschiedlicher orthogonaler Kontakte ausgespart, um erforderliche Luft- und Kriechstrecken einzuhalten.

Im Folgenden wird die Erfindung anhand der in den Figuren dargestellten Ausführungsbeispiele näher beschrieben und erläutert.

Es zeigen:
- FIG 1: eine schematische Darstellung eines Leistungsmoduls im Querschnitt,
- FIG 2: eine schematische dreidimensionale Schnittdarstellung eines Leistungsmoduls,
- FIG 3: eine schematische dreidimensionale Darstellung eines Leistungsmoduls und
- FIG 4: eine schematische Darstellung eines Stromrichters mit einem Leistungsmodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

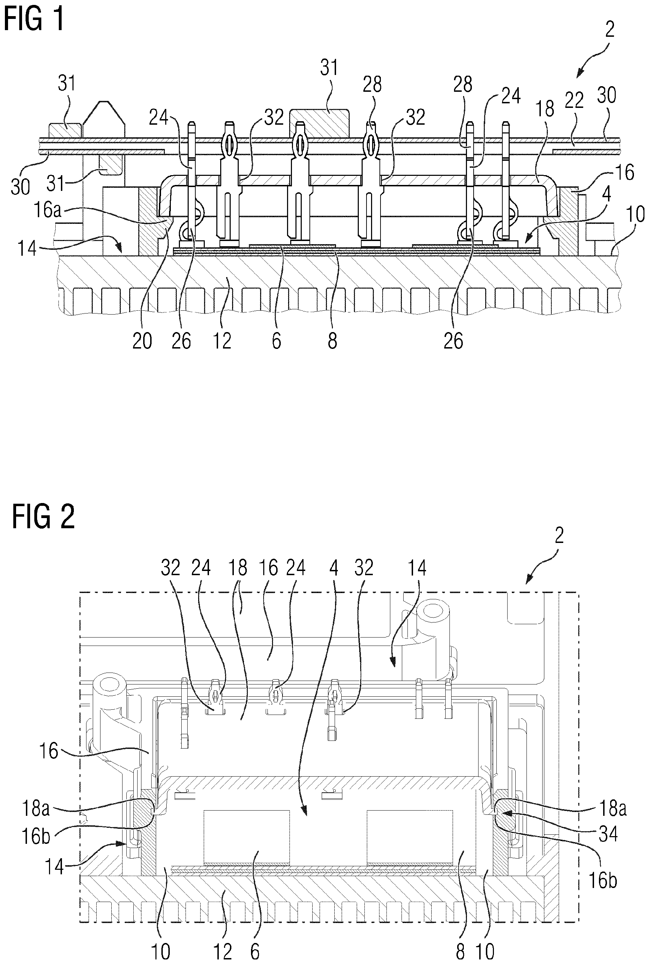

FIG 1 zeigt eine schematische Darstellung eines Leistungsmoduls 2 im Querschnitt. Das Leistungsmodul 2 weist mindestens eine Leistungseinheit 4 auf, welche Leistungshalbleiter 6 und ein Substrat 8 umfasst. Die Leistungshalbleiter 6 sind beispielsweise als Transistor, insbesondere als Insulated-Gate-Bipolar-Transistor (IGBT), als Metalloxide-Semiconductor-Field-Effect-Transistor (MOSFET) oder als Feldeffekttransistor, oder als Diode ausgeführt. Insbesondere ist zumindest einem Transistor eine antiparallele Diode zugewiesen.

Das Substrat 8 der mindestens einen Leistungseinheiten 4 weist eine dielektrische Materiallage mit einer Dicke von 25 µm bis 400 µm, insbesondere 50 µm bis 250 µm, auf, die einen keramischen Werkstoff, beispielsweise Aluminiumnitrid oder Aluminiumoxid, oder einen organischen Werkstoff, beispielsweise einem Polyamid enthält. Darüber hinaus weist das Substrat 8 eine, insbesondere strukturierte, beidseitige Metallisierung, welche beispielsweise aus Kupfer hergestellt ist, auf, wobei das Substrat 8 über die Metallisierung unmittelbar stoffschlüssig mit einer Oberfläche 10 eines Kühlkörpers 12 verbunden sind. Der Kühlkörper 12 ist beispielsweise aus Aluminium oder einer Aluminiumlegierung durch Strangpressen hergestellt. Die stoffschlüssige Verbindung zum Kühlkörper 12 wird durch Löten oder Sintern hergestellt. Unter einer unmittelbar stoffschlüssigen Kontaktierung ist eine direkte Kontaktierung zu verstehen, die Verbindungsmittel zur Herstellung der stoffschlüssigen Verbindung wie Kleber, Lötzinn, Sinterpaste, ... einschließt, ein zusätzliches Verbindungselement wie einen zusätzlichen Leiter, einen Bonddraht, einen Abstandshalter, eine Bodenplatte, Wärmeleitpaste, ... jedoch ausschließt.

Die mindestens eine Leistungseinheit 4 ist von einem Gehäuse 14 umgeben, wobei das Gehäuse 14 einen Gehäuserahmen 16 aus einem ersten dielektrischen Werkstoff und einen Gehäusedeckel 18 aus einem zweiten dielektrischen Werkstoff aufweist, wobei das Gehäuse 14 durch Verbinden des Gehäusedeckels 18 mit dem Gehäuserahmen 16 verschlossen ist. Ferner ist der Gehäusedeckel 18 formschlüssig und lösbar durch einen Überstand 16a mit dem Gehäuserahmen 16 verbunden. Der Gehäuserahmen 16 ist flüssigkeitsdicht mit der Oberfläche 10 des Kühlkörpers 12 verbunden. Das Gehäuses 14 ist bis knapp unter dem Gehäusedeckel 18 mit einem Weichverguss 20, insbesondere ein Silikonverguss, gefüllt.

Der erste dielektrische Werkstoff unterscheidet sich vom zweiten dielektrischen Werkstoff, wobei der erste dielektrische Werkstoff eine höhere Durchschlagfestigkeit und/oder eine höhere Temperaturstabilität aufweist als der zweite dielektrische Werkstoff. Darüber hinaus weist der erste dielektrische Werkstoff eine höhere mechanische Steifigkeit auf als der zweite dielektrische Werkstoff.

Beispielsweise enthält der erste dielektrische Werkstoff ein Reaktionsharz, insbesondere Epoxidharz, welches mit einem Faseranteil von 50 % bis 75 %, insbesondere 60 % bis 65 %, gefüllt ist. Der zweite dielektrische Werkstoff hingegen enthält beispielsweise einen thermoplastischen Kunststoff, der mit einem Faseranteil von 5 % bis 15 % gefüllt ist. Für die Füllung werden beispielsweise Glas- und/oder Kohlefasern verwendet.

Ein im Wesentlichen parallel zur Oberfläche 10 des Kühlkörpers 12 verlaufend angeordnetes Power-Board 22 ist über orthogonale Kontakte 24 mit der Leistungseinheit 4 verbunden, wobei die orthogonalen Kontakte 24 stoffschlüssig mit dem Substrat 8 der Leistungseinheit 4 verbunden sind. Die orthogonalen Kontakte 24 weisen einen elastisch nachgebenden Abschnitt 26 auf und sind beispielsweise mit einer Presspass-Verbindung 28 mit dem Power-Board 22 verbunden. Das Power-Board 22 weist eine, insbesondere beidseitige, Metallisierung 30 auf, wobei die Metallisierung 30 zumindest teilweise ausgespart ist, um erforderliche Luft- und Kriechstrecken auf dem Power-Board 22 einzuhalten. Insbesondere wird zwischen Potentialen unterschiedlicher orthogonaler Kontakte 24 eine Metallisierung 30 ausgespart, um erforderliche Luft- und Kriechstrecken einzuhalten. Der Gehäusedeckel 18 weist Aussparungen 32 zur Durchführung der orthogonalen Kontakte 24 auf.

FIG 2 zeigt eine schematische dreidimensionale Schnittdarstellung eines Leistungsmoduls 2. Das Leistungsmodul 2 umfasst mindestens zwei Leistungseinheiten 4. Der Gehäusedeckel 18 der jeweiligen Leistungseinheit 4 ist formschlüssig und lösbar durch eine Schnappverbindung 34 mit dem Gehäuserahmen 16 verbunden. Die Schnappverbindung wird beispielhaft über einen, zumindest im Bereich der Schnappverbindung, elastisch verformbaren Gehäusedeckel 18, hergestellt, welcher, zumindest auf zwei gegenüberliegenden Seiten, zur Herstellung der Schnappverbindung im Gehäuserahmen 16 verhakt wird. Insbesondere wird eine Nase 18a des Gehäusedeckels 18 in einer Nut 16b im Gehäuserahmen 16 verhakt. Das Power-Board 22 ist aus Gründen der Übersichtlichkeit nicht dargestellt. Die weitere Ausführung des Leistungsmoduls 2 in FIG 2 entspricht der in FIG 1.

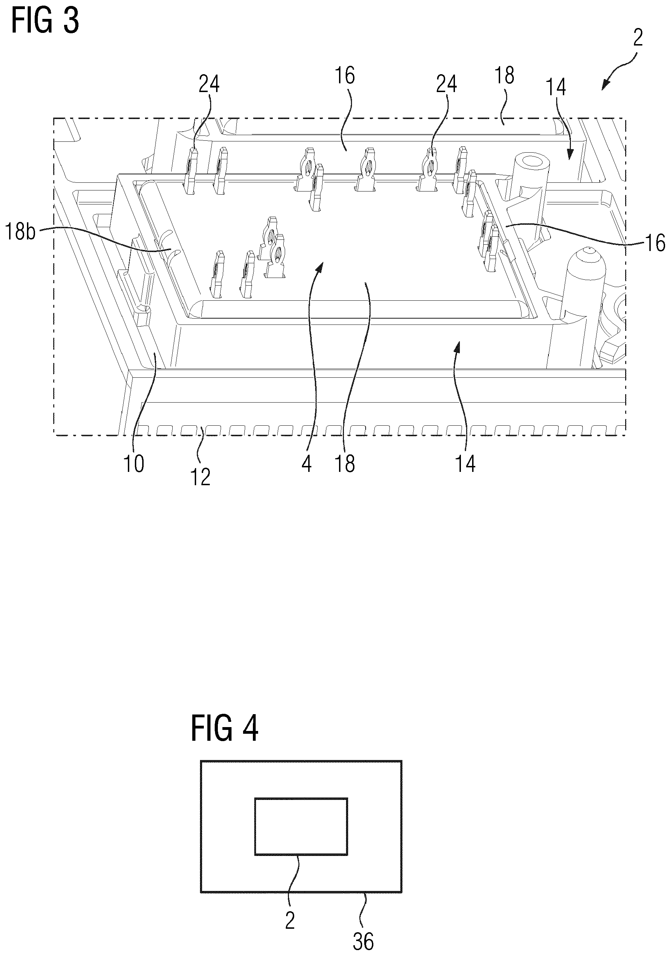

FIG 3 zeigt eine schematische dreidimensionale Darstellung eines Leistungsmoduls 2, wobei ein elastischer Bereich 18b des Gehäusedeckels 18 zur Herstellung einer lösbaren formschlüssigen Verbindung mit dem Gehäuserahmen 16 dargestellt ist. Die Ausführung des Leistungsmoduls 2 in FIG 3 entspricht der in FIG 2.

FIG 4 zeigt eine schematische Darstellung eines Stromrichters 36 mit einem Leistungsmodul 2. Der Stromrichter 36 kann mehr als ein Leistungsmodul 2 umfassen.

Zusammenfassend betrifft die Erfindung ein Leistungsmodul 2 mit mindestens einer Leistungseinheit 4, welche mindestens einen Leistungshalbleiter 6 und ein Substrat 8 umfasst. Um die Zuverlässigkeit des Leistungsmoduls 2 zu verbessern wird vorgeschlagen, dass das Substrat 8 der Leistungseinheit 4 unmittelbar stoffschlüssig mit einer Oberfläche 10 eines Kühlkörpers 12 verbunden ist, wobei die mindestens eine Leistungseinheit 4 zumindest teilweise von einem Gehäuse 14 umgeben ist, wobei das Gehäuse 14 einen Gehäuserahmen 16 aus einem ersten dielektrischen Werkstoff und einen Gehäusedeckel 18 aus einem zweiten dielektrischen Werkstoff umfasst, wobei sich der erste dielektrische Werkstoff vom zweiten dielektrischen Werkstoff unterscheidet und wobei der Gehäuserahmen 16 flüssigkeitsdicht mit der Oberfläche 10 des Kühlkörpers 12 verbunden ist und wobei das Gehäuse 14 durch Verbinden des Gehäusedeckels 16 mit dem Gehäuserahmen 16 verschlossen ist.

## Patentansprüche

1. Leistungsmodul (2) mit mindestens einer Leistungseinheit (4), welche mindestens einen Leistungshalbleiter (6) und ein Substrat (8) umfasst,
wobei das Substrat (8) der Leistungseinheit (4) unmittelbar stoffschlüssig mit einer Oberfläche (10) eines Kühlkörpers (12) verbunden ist,
wobei die mindestens eine Leistungseinheit (4) zumindest teilweise von einem Gehäuse (14) umgeben ist,
wobei das Gehäuse (14) einen Gehäuserahmen (16) aus einem ersten dielektrischen Werkstoff und einen Gehäusedeckel (18) aus einem zweiten dielektrischen Werkstoff umfasst,
wobei sich der erste dielektrische Werkstoff vom zweiten dielektrischen Werkstoff unterscheidet und
wobei der Gehäuserahmen (16) flüssigkeitsdicht mit der Oberfläche (10) des Kühlkörpers (12) verbunden ist und
wobei das Gehäuse (14) durch Verbinden des Gehäusedeckels (18) mit dem Gehäuserahmen (16) verschlossen ist.

2. Leistungsmodul (2) nach Anspruch 1,
wobei der Gehäusedeckel (18) lösbar mit dem Gehäuserahmen (16) verbunden ist.

3. Leistungsmodul (2) nach einem der Ansprüche 1 oder 2, wobei der Gehäusedeckel (18) formschlüssig mit dem Gehäuserahmen (16) verbunden ist.

4. Leistungsmodul (2) nach einem der vorherigen Ansprüche, wobei der erste dielektrische Werkstoff eine höhere Durchschlagfestigkeit und/oder eine höhere Temperaturstabilität aufweist als der zweite dielektrische Werkstoff.

5. Leistungsmodul (2) nach einem der vorherigen Ansprüche, wobei der erste dielektrische Werkstoff eine höhere mechanische Steifigkeit aufweist als der zweite dielektrische Werkstoff.

6. Leistungsmodul (2) nach einem der vorherigen Ansprüche, wobei der erste dielektrische Werkstoff ein Reaktionsharz enthält und/oder einen Faseranteil von 50 % bis 75 %, insbesondere 60 % bis 65 %, aufweist.

7. Leistungsmodul (2) nach einem der vorherigen Ansprüche, wobei der zweite dielektrische Werkstoff einen thermoplastischen Kunststoff enthält und/oder einen Faseranteil von 5 % bis 15 % aufweist.

8. Leistungsmodul (2) nach einem der vorherigen Ansprüche, wobei ein im Wesentlichen parallel zur Oberfläche (10) des Kühlkörpers (12) verlaufend angeordnetes Power-Board (22) über orthogonale Kontakte (24) mit der Leistungseinheit (4) verbunden ist,
wobei der Gehäusedeckel (18) Aussparungen (32) zur Durchführung der orthogonalen Kontakte (24) aufweist.

9. Leistungsmodul (2) nach Anspruch 8,
wobei das Power-Board (22) eine Metallisierung (30) aufweist, wobei die Metallisierung (30) zumindest teilweise ausgespart ist.

10. Stromrichter mit mindestens einem Leistungsmodul (2) nach einem der Ansprüche 1 bis 9.

11. Verfahren zur Herstellung eines Leistungsmoduls (2) mit mindestens einer Leistungseinheit (4),
welche mindestens einen Leistungshalbleiter (6) und ein Substrat (8) umfasst,
wobei das Substrat (8) der Leistungseinheit (4) unmittelbar stoffschlüssig mit einer Oberfläche (10) eines Kühlkörpers (12) verbunden ist,
wobei ein Gehäuse (14) um die mindestens eine Leistungseinheit (4) angeordnet wird,
wobei das Gehäuse (14) einen Gehäuserahmen (16) aus einem ersten dielektrischen Werkstoff und einen Gehäusedeckel (18) aus einem zweiten dielektrischen Werkstoff umfasst,
wobei sich der erste dielektrische Werkstoff vom zweiten dielektrischen Werkstoff unterscheidet,
wobei der Gehäuserahmen (16) flüssigkeitsdicht mit der Oberfläche (10) des Kühlkörpers (12) verbunden wird und
wobei das Gehäuse (14) durch Verbinden des Gehäusedeckels (18) mit dem Gehäuserahmen (16) verschlossen wird.

12. Verfahren nach Anspruch 11,
wobei der Gehäusedeckel (18) formschlüssig mit dem Gehäuserahmen (16) verbunden wird.

13. Verfahren nach einem der Ansprüche 11 oder 12,
wobei der Gehäusedeckel (18) lösbar mit dem Gehäuserahmen (16) verbunden ist.

14. Verfahren nach einem der Ansprüche 11 bis 13,
wobei ein im Wesentlichen parallel zur Oberfläche (10) des Kühlkörpers (12) verlaufend angeordnetes Power-Board (22) über orthogonale Kontakte (24) mit der Leistungseinheit (4) verbunden wird,
wobei der Gehäusedeckel (18) Aussparungen (32) zur Durchführung der orthogonalen Kontakte (24) aufweist.
